(19) Europäisches Patentamt
European Patent Office
Office européen des brevets

(11) Veröffentlichungsnummer: **0 244 748**
**B1**

(12) # EUROPÄISCHE PATENTSCHRIFT

(45) Veröffentlichungstag der Patentschrift: **16.05.90**

(51) Int. Cl.[5]: **G03F 7/038,** G03F 7/09

(21) Anmeldenummer: **87106212.1**

(22) Anmeldetag: **29.04.87**

(54) **Lichtempfindliches Gemisch und daraus hergestelltes lichtempfindliches Aufzeichnungsmaterial.**

(30) Priorität: **09.05.86 DE 3615613**

(43) Veröffentlichungstag der Anmeldung:
**11.11.87 Patentblatt 87/46**

(45) Bekanntmachung des Hinweises auf die Patenterteilung:
**16.05.90 Patentblatt 90/20**

(84) Benannte Vertragsstaaten:
**DE FR GB**

(56) Entgegenhaltungen:
**DE-A- 2 053 363**
**US-A- 3 453 237**

**RESEARCH DISCLOSURE, Band 177, Nr. 110, Juni 1973, Seiten 72-80, Nr. 11027, Industrial Opportunities Ltd, GB; "Phosphorus containing photocrosslinkable polymers"**
**PHOTOPOLYMERS: PRINCIPLES, PROCESSES & MATERIALS, REGIONAL TECHNICAL CONFERENCE, 24.-26. Oktober 1973, Seiten 10-19, Society of Plastics Engineers, Inc.; D.G. BORDEN: "Photocrosslinkable polyphosphonates having unusual resistance to acids"**

(73) Patentinhaber: **HOECHST AKTIENGESELLSCHAFT, Postfach 80 03 20, D-6230 Frankfurt am Main 80(DE)**

(72) Erfinder: **Pawlowski, Georg, Dr., Blücherstrasse 48a, D-6200 Wiesbaden(DE)**
Erfinder: **Kleiner, Hans-Jerg, Dr., Altkönigstrasse 11a, D-6242 Kronberg(DE)**

EP 0 244 748 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

## Beschreibung

Die Erfindung betrifft ein lichtempfindliches Gemisch, das als wesentliche Bestandteile eine lichtempfindliche Verbindung und ein polymeres, wasserunlösliches, in wäßrig-alkalischen Lösungen lösliches oder quellbares Bindemittel enthält und das in hervorragender Weise zur Herstellung gedruckter Schaltungen in der Resisttechnik, insbesondere aber von Flachdruckformen für den Offsetdruck geeignet ist.

Gemische dieser Gattung sind aus der DE-A 20 53 363 bekannt. Sie enthalten als Bindemittel Umsetzungsprodukte aus einem Hydroxyl- oder Aminogruppen enthaltenden Polymeren und mindestens einem gesättigten Alkyl-, Alkoxy-, Aryl- oder Aryloxysulfonylisocyanat. Das Bindemittel wird in Kombination mit Diazoniumsalz-Kondensationsprodukten oder photopolymerisierbaren Gemischen zu lichtempfindlichen Schichten verarbeitet. Die dabei erhaltenen Gemische lassen sich allerdings nur dann wäßrig-alkalisch entwickeln, wenn die eingesetzten Bindemittel hohe Säurezahlen aufweisen, wodurch die Abriebbeständigkeit und auch die Druckeigenschaften der gehärteten Schicht nachteilig beeinflußt werden.

Ähnliche Gemische sind in der DE-A 20 53 364 beschrieben. Sie enthalten Umsetzungsprodukte aus Hydroxyl- oder Aminogruppen enthaltenden Polymeren und ungesättigten Sulfonylisocyanaten sowie einen Initiator und gegebenenfalls weitere polymerisierbare Verbindungen.

Umsetzungsprodukte der gleichen Art in Kombination mit Diazoniumsalz-Polykondensaten oder niedermolekularen Aziden sind in der DE-A 30 36 077 beschrieben.

Nachteilig an diesen Gemischen ist einerseits die aufwendige und kostspielige Herstellung der erforderlichen Alkenylsulfonylisocyanate. Weiterhin zeigen die daraus hergestellten Druckplatten eine unzureichende Farbannahme, so daß beim Andruckprozeß und nach längerem Stillstand ein unvertretbar hoher Makulaturanfall entsteht.

Aufgabe der vorliegenden Erfindung war es daher, ein lichtempfindliches Gemisch vorzuschlagen, das die bereits bestehenden Vorzüge der Gemische mit aus Sulfonylisocyanaten dargestellten Bindemitteln aufweist, andererseits aber lichtempfindliche Schichten mit besserer Abriebbeständigkeit nach dem Belichten und Druckplatten mit besserer Farbannahme liefert und das aus leicht zugänglichen Ausgangsstoffen hergestellt werden kann.

Erfindungsgemäß wird ein lichtempfindliches Gemisch vorgeschlagen, das als wesentliche Bestandteile eine lichtempfindliche Verbindung und ein polymeres wasserunlösliches, in wäßrig-alkalischen Lösungen lösliches oder quellbares Bindemittel enthält.

Das erfindungsgemäße Gemisch ist dadurch gekennzeichnet, daß das polymere Bindemittel ein Umsetzungsprodukt einer Verbindung der allgemeinen Formel I

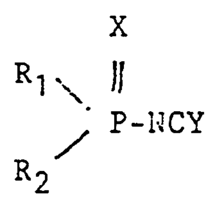

(I)

,

worin

X und Y gleich oder verschieden sind und Sauerstoff oder Schwefel bedeuten,

$R_1$ und $R_2$ gleich oder verschieden sind und ggf. substituierte Alkyl-, Cycloalkyl- oder Alkoxyreste mit 1 bis 6 C-Atomen, ggf. substituierte Aryl- oder Aryloxyreste mit 6 bis 10 C-Atomen oder gemeinsam mit dem Phosphoratom einen 5- oder 6-gliedrigen heterocyclischen Ring bedeuten, der ggf. substituiert ist oder einen ankondensierten Benzolring trägt,

mit einem aktiven Wasserstoff enthaltenden Polymeren ist.

Die in dem erfindungsgemäßem Gemisch enthaltenen polymeren Bindemittel weisen als funktionelle Gruppen seitenständige, (Thio)phosphinylurethan- oder -thiourethan- bzw. -harnstoff- oder -thioharnstoffgruppen auf. Diese Verbindungen entstehen durch Umsetzung von Verbindungen der Formel I mit aktiven Wasserstoff enthaltenden Polymeren, z. B. mit Hydroxyl- oder Aminogruppen enthaltenden Polymeren.

$R_1$ und $R_2$ sind vorzugsweise Alkyl- oder Alkoxyreste mit 1 bis 4, insbesondere 1 oder 2 C-Atomen oder ggf. substituierte Phenyl- oder Phenoxyreste. Als Substituenten kommen Halogenatome, insbesondere Chlor, Alkylreste oder Alkoxyreste mit 1 bis 4 C-Atomen in Betracht. Die aromatischen Reste $R_2$ können 1 bis 3, vorzugsweise 1 oder 2 Substituenten enthalten oder unsubstituiert sein.

Des weiteren können $R_1$ und $R_2$ gemeinsam ein phosphorheterocyclisches, ggf. auch aus mehr als einem 5- oder 6-gliedrigen, auch ungesättigten und/oder substituierten Ring bestehendes Ringsystem bilden. Zu nennen sind Ringsysteme, die sich vom Phosphol, Phospholin, Phospholan, Phosphorinan, Diphosphan sowie Phosphindol, Phosphindolin, Isophosphindolin, Tetrahydrophosphinolin und Tetrahydroisophosphinolin als Grundkörper ableiten.

Als bevorzugte (Thio)phosphinsäureiso(thio)cyanate der Formel I werden genannt:

Dimethylphosphinsäureisocyanat,
Dimethylthiophosphinsäureisocyanat,
Dimethylphosphinsäureisothiocyanat,
Ethylmethylthiophosphinsäureisothiocyanat,
Diethylphosphinsäureisocyanat,
Diethylthiophosphinsäureisothiocyanat,
Methylbutylphosphinsäureisocyanat,
Dibutylphosphinsäureisocyanat,
Dihexylphosphinsäureisocyanat,
Chlormethylmethylphosphinsäureisocyanat,
Chlormethylethylphosphinsäureisocyanat,
Methylphenylphosphinsäureisocyanat,
Methylphenylphosphinsäureisothiocyanat,
Diphenylphosphinsäureisocyanat,
Diphenylphosphinsäureisothiocyanat,
Ethoxyphenylphosphinsäureisocyanat,
Diethoxyphosphinsäureisocyanat,
Diethoxyphosphinsäureisothiocyanat,
Dibutoxyphosphinsäureisocyanat,
Diphenoxythiophosphinsäureisocyanat,
1-Isocyanato-1-oxo-2,3-dihydrophosphol,
1-Isocyanato-1-oxo-2,5-dihydrophosphol.

Die genannten (Thio)phosphinsäurederivate lassen sich aus den entsprechenden (Thio)phosphinsäurechloriden der allgemeinen Formel II

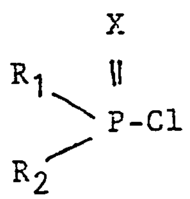

(II)

worin $R_1$, $R_2$ und X die oben angegebenen Bedeutungen haben, durch Umsetzung mit anorganischen Cyanaten bzw. Thiocyanaten herstellen. Die Herstellung dieser Zwischenprodukte ist z. B. in Houben-Weyl, Methoden der Organischen Chemie, Band E 2, S. 241, beschrieben.

Die zur Umsetzung mit diesen Verbindungen befähigten, aktiven Wasserstoff enthaltenden Polymeren sind bevorzugt Hydroxyl- oder Aminogruppen aufweisende Polymere. Unter ihnen sind solche, die Hydroxylgruppen tragen, gegenüber solchen mit Aminogruppen bevorzugt, da die Urethangruppen enthaltenden, lichtempfindlichen Polymeren wesentlich besser in wäßrig-alkalischen Entwicklerlösungen löslich sind als solche, die Harnstoffgruppen aufweisen. Darüber hinaus sind die Umsetzungsprodukte mit Harnstoffgruppen häufig spröder und schlechter verarbeitbar.

Die gute Löslichkeit der (Thio)urethan- bzw. (Thio)-harnstoffgruppen aufweisenden Polymeren in wäßrig-alkalischen Lösungen resultiert aus dem sauren Charakter der am Stickstoff gebundenen Wasserstoffatome infolge der Aktivierung durch die benachbarten Carbonyl- bzw. Phosphinsäuregruppen.

Als hydroxylgruppenhaltige Ausgangspolymere können beispielsweise Vinyl- oder Allylalkoholpolymerisate Verwendung finden. Bevorzugt eingesetzt werden Vinylalkoholpolymerisate, insbesondere teilacetalisierter oder teilveresterter Polyvinylalkohol. Unter diesen sind Polyvinylacetale bevorzugt, von denen insbesondere Polyvinylformale oder Polyvinylbutyrale mit mittleren Molekulargewichten zwischen 5.000 und 200.000 oder darüber, bevorzugt von 10.000 bis 100.000, und mit 5 bis 30 Gew.-% Vinylalkoholeinheiten Einsatz finden. Allylalkoholcopolymere können als Comonomereinheiten beispielsweise Styrol- oder substituierte Styroleinheiten enthalten, wobei der Allylalkoholanteil bevorzugt zwischen 10 und 40 Gew.-% beträgt. Darüber hinaus lassen sich Mischpolymerisate aus Vinyl- oder Allylalkohol mit Vinylestern, Vinylethern, Vinylidenchlorid, Acrylaten, Methacrylaten oder (Meth)acrylnitril als Ausgangsmaterialien einsetzen.

Homopolymerisate oder Copolymerisate von Hydroxyalkyl(meth)acrylaten oder Glycerinmono(meth)acrylaten mit anderen bekannten (Meth)acrylaten, z. B. Methyl(meth)acrylat, Hexyl(meth)acrylat, (Meth)acrylnitril oder ähnlichen, lassen sich ebenfalls mit günstigen Ergebnissen

als Hydroxylgruppen enthaltende Ausgangspolymere verwenden, wenn sie mehr als 10 Gew.-% Hydroxyalkyl(meth)acrylat- oder Glycerinmono(meth)acrylateinheiten enthalten.

Auch Epoxyharze, z. B. Kondensationsprodukte aus 2,2-Bis-(4-hydroxyphenyl)propan und Epichlorhydrin, oder Umsetzungsprodukte aus teilweise umgesetzten Glycidylmeth)acrylaten lassen sich mit Vorteil verwenden, sofern diese Polymeren eine ausreichende Anzahl an freien reaktionsfähigen Hydroxylgruppen aufweisen und Molekulargewichte zwischen 2.000 und 200.000 besitzen.

Celluloseether und Celluloseester kommen ebenfalls in Betracht, sofern sie unumgesetzte Hydroxylgruppen aufweisen. Hier sind insbesondere die Partialester mit niedrigen aliphatischen Carbonsäuren zu nennen, wie beispielsweise Celluloseacetat. Geeignete Celluloseether sind beispielsweise gemischte Alkylhydroxyalkylether der Cellulosen. Bevorzugt sollten zwischen 0,3 und 2,3 freie Hydroxylgruppen pro Glucoseeinheit vorhanden sein.

Zu den kondensierbaren Polyestern gehören solche Verbindungen, die nicht vollständig verestert sind und aus Verzweigungen resultierende oder endständige Hydroxylgruppen enthalten, wobei der Grad der Verzweigung nicht zu hoch sein sollte.

Schließlich sind auch aminogruppenhaltige Verbindungen als Ausgangspolymere für die Umsetzung mit den ethylenisch ungesättigten (Thio)phosphinsäureisocyanaten und -isothiocyanaten der allgemeinen Formel I verwendbar, wobei die daraus resultierenden Polymeren infolge ihrer häufig beobachtbaren Sprödigkeit jedoch nicht bevorzugt sind. Zudem lassen sie sich oft nicht rasch genug mit den wäßrig-alkalischen Entwicklerlösungen entwickeln, wobei die Polymeren gelegentlich noch zu stark am metallischen Substrat haften. Namentlich erwähnt seien jedoch Copolymere des N-Vinyl-N-methylamins sowie Polyamide, z. B. Polycaprolactam und Polyurethane, z. B. Umsetzungsprodukte von Diisocyanaten mit zwei- oder mehrwertigen Alkoholen, oder Polyamidimide.

Werden die polymeren Bindemittel im Offsetbereich eingesetzt, so sind die Umsetzungsprodukte mit Polyvinylacetalen besonders bevorzugt, während für Anwendungen in der Resisttechnik Copolymerisate des Hydroxyalkyl(meth)acrylats mit niedrigeren Molekulargewichten besonders geeignet sind.

Der Mengenanteil der Polymeren in dem erfindungsgemäßen Gemisch beträgt im allgemeinen 20 bis 95, vorzugsweise 40 bis 90 Gew.-%, bezogen auf die nichtflüchtigen Bestandteile.

Die Herstellung der Polymeren ist nicht kritisch, da die (Thio)phosphinsäureisocyanate und -isothiocyanate der allgemeinen Formel I überaus leicht mit Gruppierungen reagieren, die aktive Wasserstoffatome aufweisen, so daß bisweilen auf einen Zusatz von Katalysatoren oder eine Erhöhung der Reaktionstemperatur verzichtet werden kann.

Im allgemeinen wird zur Herstellung der polymeren Bindemittel das aktiven Wasserstoff enthaltende Polymere in einem geeigneten, inerten Lösungsmittel, wie Dioxan, Tetrahydrofuran, Ethylenglykoldimethylether, Ethylenglykoldiacetat oder Butanon zu 2 bis 25 Gew.-% gelöst, und das entsprechende Isocyanat, bevorzugt gelöst im gleichen Lösungsmittel, wird bei Raumtemperatur zugetropft. Dabei läßt sich ein geringfügiges Ansteigen der Temperatur des Reaktionspgemischs beobachten.

Werden die Isothiocyanate der allgemeinen Formel I umgesetzt, so ist es sinnvoll, oben beschriebener Mischung einen Katalysator, beispielsweise Diazabicyclo[2,2,2]octan, zuzusetzen und bzw. oder die Mischung zu erwärmen.

Pro mol aktiven Wasserstoffs werden bevorzugt 0,4 bis 1,4 mol (Thio)phosphinsäureisocyanat und 0,4 bis 1,7 mol (Thio)phosphinsäureisothiocyanat zugegeben, da für einen quantitativen Umsatz aller reaktionsfähigen Gruppen des Ausgangspolymeren ein Überschuß der Verbindungen der allgemeinen Formel I notwendig ist.

Die alkalilöslichen Polymeren können, gegebenenfalls nach Zerstörung überschüssigen Isocyanats oder Isothiocyanats durch Zugabe eines Alkohols, z. B. von Ethanol, in der Reaktionslösung weiterverarbeitet werden.

Zum Zweck der Charakterisierung oder für spezielle Anwendungen kann das Polymere durch Eintropfen in die 10-fache Menge eines Nichtlösemittels, bevorzugt in leicht angesäuertes Wasser, isoliert werden, wobei es als farbloses bis schwach gelbliches, amorphes, im allgemeinen jedoch gut filtrierbares Produkt anfällt. Das Produkt sollte vor der Anwendung in dem erfindungsgemäßen lichtempfindlichen Gemisch ausreichend getrocknet sein.

Die derart erhältlichen polymeren Bindemittel ergeben in Kombination mit den unterschiedlichsten negativ arbeitenden lichtempfindlichen Substanzen, wie Diazoniumsalz-Polykondensaten, photopolymerisierbaren Gemischen, Azidoderivaten oder Chinondiaziden leicht und schleierfrei mit wäßrig-alkalischen Lösungen entwickelbare Schichten, die sich durch hohe Abriebbeständigkeit und ausgezeichnete Wärmestandfestigkeit auszeichnen und daher für zahlreiche Anwendungsmöglichkeiten einsetzbar sind, wobei insbesondere die Herstellung lithographischer Platten und Photoresists erwähnt werden sollen.

Als negativ arbeitende lichtempfindliche Substanzen lassen sich praktisch alle bekannten Verbindungen einsetzen, sofern sie mit der polymeren Matrix verträglich sind.

Beispielsweise sind Diazoniumsalz-Polykondensationsprodukte sehr gut geeignet, z. B. Kondensationsprodukte kondensationsfähiger aromatischer Diazoniumsalze mit Aldehyden. Als Beispiele seien Kondensationsprodukte von Diphenylamin-4-diazoniumsalzen mit Formaldehyd erwähnt. Vorteilhafterweise werden jedoch Mischkondensationsprodukte eingesetzt, welche außer den Diazonumsalzeinheiten weitere, nicht lichtempfindliche Einheiten enthalten, welche sich von kondensationsfähigen Verbindungen ableiten. Derartige Kondensationsprodukte sind aus den DE-A 20 24 242, 20 24 243 und 20 24 244 bekannt. Allgemein sind jedoch alle Diazoniumsalz-Kondensate geeignet, welche in der DE-A 27 39 774 beschrieben sind.

Photopolymerisierbare Gemische, bestehend aus einem photopolymerisierbaren Mono- oder Oligomeren und Photoinitiatoren sind vorteilhaft als lichtempfindliche Bestandteile im erfindungsgemäßen Gemisch einsetzbar, insbesondere im Anwendungsbereich gedruckter Schaltungen.

Geeignete polymerisierbare Verbindungen sind aus den US-A 2 760 683 und 3 060 023 bekannt. Beispiele sind Acryl- oder Methacrylsäureester, wie Diglycerindiacrylat, Guajakolglycerinetheracrylat, Neopentylglykoldiacrylat, 2,2-Dimethylol-butan-3-ol-diacrylat, Pentaerythrittri- und -tetraacrylat sowie die entsprechenden Methacrylate. Geeignet sind ferner Acrylate oder Methacrylate, die Urethangruppen enthalten, sowie Acrylate bzw. Methacrylate hydroxylgruppenhaltiger Polyester. Schließlich sind auch Allyl- oder Vinylgruppen enthaltende Präpolymere geeignet, wobei insbesondere solche Monomeren oder Oligomeren bevorzugt werden, die mindestens zwei polymerisierbare Gruppen pro Molekül enthalten.

Die polymerisierbaren Verbindungen können im allgemeinen in einer Menge bis zu 50, vorzugsweise von 10 bis 35 Gew.-% bezogen auf die nichtflüchtigen Bestandteile, in dem erfindungsgemäßen Gemisch enthalten sein.

Als Photoinitiatoren im erfindungsgemäßen lichtempfindlichen Gemisch können zahlreiche Substanzen Verwendung finden. Beispiele sind Benzoine, Benzoinether, Mehrkernchinone, wie 2-Ethylanthrachinon, Acridinderivate, wie 9-Phenylacridin oder Benzacridine, Phenazinderivate, wie 9,10-dimethylbenz[a]phenazin, Chinoxalin- oder Chinolinderivate, wie 2,3-Bis-(4-methoxyphenyl)chinoxalin oder 2-Styrylchinolin, Chinazolinverbindungen oder Acylphosphinoxidverbindungen. Photoinitiatoren dieser Art sind in den DE-C 20 27 467, 20 39 861 und der EP-B 11 786 beschrieben. Außerdem können beispielsweise Hydrazone, Mercaptoverbindungen, Pyrylium- oder Thiopyryliumsalze, synergistische Mischungen mit Ketonen oder Hydroxyketonen und Farbstoff-Redoxsysteme in Frage kommen. Besonders bevorzugt sind Photoinitiatoren, die durch Licht spaltbare Trihalogenmethylgruppen aufweisen, wobei insbesondere entsprechende Verbindungen aus der Triazin- oder Thiazolinreihe erwähnt sein sollen. Solche Verbindungen sind in den DE-A 27 18 259, 33 33 450 und 33 37 024 beschrieben. Vorzugsweise ist 2-(4'-Methoxystyryl)-4,6-bis-trichlormethyl-s-triazin zu nennen.

Die Photoinitiatoren werden im allgemeinen in Mengenanteilen von 0,1 bis 15, vorzugsweise von 0,5 bis 10 Gew.-%, bezogen auf die nichtflüchtigen Bestandteile des Gemischs, zugesetzt.

Für gewisse Anwendungen sind als lichtempfindliche Verbindungen nieder- oder höhermolekulare Azidoderivate besonders geeignet, wobei niedermolekulare Azidoverbindungen mit mindestens zwei Azidogruppen pro Molekül bevorzugt werden. Als Beispiele seien 4,4'-Diazidostilbene, 4,4'-Diazidobenzophenone, 4,4'-Diazidobenzalacetophenone, 4,4'-Diazidobenzalacetone oder 4,4'-Diazidobenzalcyclohexanone genannt. Die Lichtempfindlichkeit derartiger Azidoverbindungen kann gegebenenfalls durch Verwendung geeigneter Sensibilisatoren, z. B. von 1,2-Benzanthrachinon, verstärkt werden. Weiterhin geeignet sind auch solche polyfunktionellen Azide, deren Eigenabsorption durch Konjugation mit Doppelbindungen im Molekül so verschoben ist, daß keine zusätzliche Sensibilisierung bei der Belichtung erforderlich ist. Weitere geeignete Azidoverbindungen sind aus der GB-A 790 131, der DE-C 950 618 und der US-A 2 848 328 bekannt.

Schließlich lassen sich auch niedermolekulare Diazoverbindungen, wie p-Chinondiazide oder p-Iminochinondiazide als lichtempfindliche Verbindungen verwenden. Derartige Mischungen sind aber wegen der geringen Lichtempfindlichkeit nicht bevorzugt.

Die Menge der lichtempfindlichen vernetzbaren Verbindung kann im allgemeinen 5 bis 60, vorzugsweise 10 bis 40 Gew.-%, bezogen auf die nichtflüchtigen Bestandteile des Gemischs, betragen.

Die erfindungsgemäßen gemische lassen sich auf bekannte Weise entsprechend ihrem Anwendungszweck verarbeiten. Dazu wird das polymere Umsetzungsprodukt in einem geeigneten Lösungsmittel oder Lösungsmittelgemisch, aus dem die Beschichtung erfolgen soll, z. B. Ethylenglykolmonomethylether, Ethylenglykolmonoacetat, Dioxan, Tetrahydrofuran oder Butanon, gelöst, und mit einer in dieser Mischung löslichen lichtempfindlichen Substanz versetzt.

Des weiteren können je nach Art der lichtempfindlichen Verbindung folgende Zusätze zur lichtempfindlichen Beschichtungslösung zugefügt werden

a) bei Sensibilisierung mit Diazoverbindungen, beispielsweise p-Chinondiaziden oder Diazoniumsalz-Kondensaten:

ein Farbstoff zur Sichtbarmachung der lichtempfindlichen Schicht auf dem Trägermaterial; eine Säure, bevorzugt Phosphorsäure, zur Stabilisierung des Diazoniumsalzes und ein Kontrastbildner, der eine Verstärkung der Farbänderung der Schicht bei Belichtung bewirkt,

b) bei Sensibilisierung mit Azidoverbindungen:

ein Farbstoff, der zur Sichtbarmachung der lichtempfindlichen Schicht und zur Empfindlichkeitserhöhung der lichtvernetzenden Verbindung im gewünschten Spektralbereich beiträgt,

c) bei Sensibilisierung mit photopolymerisierbaren Substanzen:

Inhibitoren, welche eine thermisch ausgelöste Polymerisation unterdrücken.

Des weiteren können andere Zusätze, z. B. Weichmacher, Pigmente, weitere Harzkomponenten etc. dem lichtempfindlichen Gemisch zugefügt werden, sofern sie sich für den jeweiligen Anwendungszweck als geeignet erweisen. Derartige Zusätze, ihre Wirkungen und Verwendungsmöglichkeiten sind dem Fachmann bekannt.

Zur Weiterverarbeitung werden die erhaltenen Lösungen filtriert, um gegebenenfalls ungelöste Bestandteile zu entfernen, und in an sich bekannter Weise, z. B. durch Rakeln oder Schleudern, auf ein geeignetes Trägermaterial aufgetragen und getrocknet.

Als Trägermaterialien seien insbesondere Aluminium, welches mechanisch oder elektrochemisch aufgerauht und ggf. anodisiert und nachbehandelt worden ist, aluminiumkaschierte oder andersartig hydrophilierte Folien, kupferbedampfte Folien oder Mehrmetallfolien genannt.

Die Art des Auftrags hängt dabei in hohem Maß von der gewünschten Schichtdicke der lichtempfindlichen Schicht ab, wobei die bevorzugten Schichtdicken der getrockneten Schicht zwischen 0,5 und 200 µm liegen.

Nach ausreichender Trocknung können die Materialien in an sich bekannter Weise durch bildmäßige Belichtung mittels einer Negativ-Filmvorlage oder bei geeigneter Sensibilisierung mittels eines Laserstrahls und anschließende Entwicklung in ihre jeweilige Anwendungsform übergeführt werden.

Die Entwicklung erfolgt dabei bevorzugt mit wäßrig-alkalischen Entwicklerlösungen, deren pH-Wert im Bereich zwischen etwa 8 und 13 liegt. Gegebenenfalls können die Entwickler Zusätze enthalten, die zu einem beschleunigten, praxisgerechten Entwicklungsvorgang beitragen. Als für diesen Zweck geeignete Zusätze seien insbesondere Tenside oder geringe Mengen eines wenig flüchtigen organischen Lösungsmittels, wie Benzylalkohol erwähnt. Die Zusammensetzung geeigneter Entwicklerlösungen für die erfindungsgemäßen lichtempfindlichen Schichten ist in erster Linie vom jeweiligen Anwendungszweck abhängig; sie sollten jedoch in der Regel mehr als 75 Gew.-% Wasser und weniger als 5 Gew.-% eines organischen Lösungsmittels enthalten. Geeignete Entwicklerlösungen sind z. B. aus den DE-A 28 09 774, 31 00 259 oder 31 40 186 bekannt.

Die erfindungsgemäßen Gemische erlauben die Herstellung von Flachdruckformen mit sehr hoher Auflage. Diese zeigen eine günstige Farbannahme unter Beibehaltung günstiger kopiertechnischer Eigenschaften. Für diesen Einsatzbereich sind als Bindemittel insbesondere Umsetzungsprodukte aus Polyvinylacetalen und Phosphinsäureisocyanaten der Formel I geeignet. Die aus lichtempfindlichen Gemischen mit diesen Polymeren erhaltenen Flachdruckplatten zeigen darüber hinaus eine leichte, schleierfreie Entwickelbarkeit mit wäßrig-alkalischen Entwicklerlösungen und eine sehr günstige Lagerungsbeständigkeit.

Mit den erfindungsgemäßen Gemischen sind weiterhin Photoresistschablonen ausgezeichneter Auflösung erhältlich. Für diesen Anwendungszweck sind jedoch als Bindemittel eher Umsetzungsprodukte von Copolymerisaten des Hydroxyalkyl(meth)acrylats mit den Phosphinsäureisocyanaten der allgemeinen Formel I bevorzugt.

Die nachstehenden Beispiele sollen die Erfindung und ihre Anwendungsmöglichkeiten näher erläutern. Gewichtsteile (Gt) und Volumenteile (Vt) stehen im Verhältnis von g/cm³; Prozentzahlen und Mengenverhältnisse sind, wenn nichts anderes angegeben ist, in Gewichtsteilen zu verstehen.

Herstellungsbeispiel 1:

Ethylmethylphosphinsäureisocyanat

Zu 112 g Ethylmethylphosphinsäurechlorid in 200 ml absolutem Acetonitril wurden portionsweise 58 g Natriumcyanat gegeben, wobei eine Temperatur von 30° C nicht überschritten wurde. Die Reaktionsmischung wurde drei Tage nachgerührt, das Produkt abgesaugt und das Lösungsmittel im Wasserstrahlvakuum entfernt. Der Rückstand wurde destilliert. Es konnten 72 g (60,5 % d. Th.) einer farblosen, leicht beweglichen Flüssigkeit vom Siedepunkt 75-77° C / 100 Pa isoliert werden.

Herstellungsbeispiel 2:

Dibutoxyphosphinsäureisocyanat

Analog zu Beispiel 1 wurden 200 g Dibutoxyphosphinsäurechlorid mit 58 g Natriumcyanat in 350 ml absolutem Acetonitril umgesetzt. Es konnten 142 g (69 % d. Th.) einer schwach gelblichen Flüssigkeit vom Siedepunkt 80-83° C / 0,67 Pa isoliert werden.

Herstellungsbeispiel 3:

Dimethylthiophosphinsäureisocyanat

Analog zu Beispiel 1 wurden 112 g Dimethylthiophosphinsäurechlorid mit 58 g Natriumcyanat in 200 ml absolutem Acetonitril umgesetzt. Es konnten 98 g (81 % d. Th.) farblose Kristalle vom Schmelzpunkt 77-79° C (Umkristallisation aus Toluol) isoliert werden.

Herstellungsbeispiel 4:

Umsetzung eines Polyvinylbutyrals mit Ethylmethylphosphinsäureisocyanat

20 g eines Polyvinylbutyrals mit einem Molekulargewicht von etwa 70.000 - 80.000, das 71 Gew.-% Vinylbutyral, 2 Gew.-% Vinylacetat- und 27 Gew.-% Vinylalkoholeinheiten enthielt, wurden in 350 g Tetrahydrofuran gelöst. Zur klaren Lösung wurde bei Raumtemperatur eine Lösung von 10,6 g Ethylmethylphosphinsäureisocyanat in 50 g Tetrahydrofuran innerhalb von 10 Minuten unter Rühren zugetropft. Die Temperatur des Gemischs stieg um etwa 3 - 5° C an. Die Reaktionsmischung wurde 4 Stunden bei Raumtemperatur nachgerührt und anschließend in 5.000 g Wasser eingetropft. Das so erhaltene weiße, faserige Produkt wurde abgesaugt und bei 50° C im Vakuum getrocknet. Man erhielt 28 g eines Polymeren mit der Säurezahl 80.

Herstellungsbeispiel 5:

Umsetzung eines Styrol-Allylalkohol-Copolymeren mit Dibutoxyphosphinsäureisocyanat

20 g eines Styrol-Allylalkohol-Copolymeren mit einem Molekulargewicht von etwa 1.600 und einer OH-Zahl von ca. 225 wurde in 300 g Tetrahydrofuran gelöst. Unter Rühren wurden zur Lösung bei Raumtemperatur 14 g Dibutoxyphosphinsäureisocyanat in 50 g Tetrahydrofuran getropft. Die sich leicht erwärmende Mischung wurde 4 Stunden bei Raumtemperatur nachgerührt und dann in 4000 g destilliertes Wasser getropft, wobei ein körniges Polymerisat erhalten wurde, welches abgesaugt und bei 50° C getrocknet wurde. Man erhielt 31 g eines farblosen Polymeren mit einer Säurezahl von 95.

Herstellungsbeispiel 6:

Umsetzung eines hydroxylgruppenhaltigen Polyesters mit Dimethylthiophosphinsäureisocyanat

20 g eines Polyesters (Desmophen 650(R), Bayer AG) mit einer OH-Zahl von etwa 250 wurden in 300 g Butanon gelöst. Zur klaren, gerührten Lösung wurden 0,2 g Diazabicyclo[2,2,2,]octan zugefügt und anschließend bei Raumtemperatur 15 g Dimethylthiophosphinsäureisocyanat in 50 g Butanon zugetropft. Die sich dabei nur unwesentlich erwärmende Mischung wurde zur Vervollständigung der Umsetzung 4 Stunden lang bei ca. 55° C nachgerührt. Zur Zersetzung überschüssigen Isocyanats wurden nach Abkühlen 30 g Ethanol zugegeben, und die klare Lösung wurde in 5000 g Wasser eingetropft. Das ausgefallene, feinkörnige Granulat wurde abfiltriert und getrocknet. Es konnten 29 g eines gelblichen, spröden Produkts mit einer Säurezahl von 63 isoliert werden.

Weitere Bindemittelvarianten lassen sich auf ähnliche Weise wie nach den oben beschriebenen Herstellungsverfahren synthetisieren.

Anwendungsbeispiel 1

20 Gt eines Polyvinylbutyrals mit einem Molekulargewicht über 80.000, das 77-80 Gew.-% Vinylbutyral-, 2 Gew.-% Vinylacetat-und 18-21 Gew.-% Vinylalkohol-Einheiten enthielt, wurden in 350 Gt Tetrahydrofuran klar gelöst. Zu dieser Lösung wurden 17 Gt 1-Isocyanato-1-oxo-2,5-dihydrophosphol (hergestellt durch Umsetzen von 1-Chlor-1-oxo-2, 5-dihydrophosphol mit Natriumcyanat) in 50 Vt Tetrahydrofuran bei Raumtemperature zugetropft. Die Mischung wurde 4 Stunden lang nachgerührt, mit 50 Gt Ethanol versetzt und anschließend in 5000 Gt heftig gerührtes destilliertes Wasser eingetropft. Es fiel ein faseriges, amorphes Produkt an, das abgesaugt und getrocknet wurde. Man erhielt 29 Gt eines weißen Polymeren, das eine Säurezahl von 83 und eine Zusammensetzung von C: 55,6 %, H: 8,2 %, N: 3,2 % und P: 8,7 % aufwies.

Eine Beschichtungslösung wurde aus

34,8 Gt des oben beschriebenen Umsetzungsprodukts
11,6 Gt eines Diazoniumsalz-Polykondensationsprodukts, hergestellt aus 1 mol 3-Methoxydiphenylamin-4-diazoniumsulfat und 1 mol 4,4'-Bis(methoxymethyl)diphenylether in 85 %iger Phosphorsäure und isoliert als Mesitylensulfonat,
1,4 Gt Phosphorsäure (85 %),
1,8 Gt Viktoriareinblau FGA (C.I. Basic Blue 81) und
0,4 Gt Phenylazodiphenylamin in
1650,0 Gt Ethylenglykolmonomethylether und
320,0 Gt Tetrahydrofuran

hergestellt.

Die filtrierte Lösung wurde auf eine 0,3 mm starke Aluminiumfolie, die durch Bürsten mit einer wäßrigen Schleifmittelsuspension aufgerauht und danach mit einer 0,1 %igen wäßrigen Lösung von Polyvinylphosphonsäure vorbehandelt worden war, aufgebracht und anschließend getrocknet.

Die so erhaltene Kopierschicht, die ein Trockenschichtgewicht von 0,97 g/m² aufwies, wurde unter einer Negativvorlage 28 Sekunden mit einer Metallhalogenid-Lampe von 5 kW Leistung belichtet.

Die belichtete Schicht wurde mit einer Entwicklerlösung der folgenden Zusammensetzung

5,0 Gt Natriumlaurylsulfat,
1,5 Gt Natriummetasilikat × 5 $H_2O$ und
1,0 Gt Trinatriumphosphat × 12 $H_2O$ in
92,5 Gt entsalztem Wasser

mittels eines Plüschtampons behandelt, wobei die nichtbelichteten Schichtbereiche sofort nach der Benetzung durch die Entwicklerflüssigkeit entfernt wurden. Anschließend wurde mit Wasser abgespült und getrocknet.

In der Kopie war die Stufe 5 eines Silberfilm-Halbtonstufenkeils mit einem Dichteumfang von 0,05 bis 3,05 und Dichteinkrementen von 0,15 voll abgebildet. Auch feinste Raster und Linien der Vorlage wurden klar wiedergegeben. Die so erhaltene Druckform lieferte auf einer Bogenoffsetmaschine 35.000 gute Drucke.

Anwendungsbeispiel 2

In 400 ml einer 13,5 %igen wäßrigen Lösung eines Polyvinylalkohols (Mowiol(R)4-98, Hoechst AG) wurden unter Rühren 42 g Benzaldehyd dispergiert. Zu dieser Mischung wurde eine Lösung von 0,5 g 2,6-Di-tert-butyl-1,4-kresol, 0,5 g Natriumdodecylsulfat und 27,5 g konz. Salzsäure in 80 ml Wasser tropfenweise zugefügt. Das Gemisch wurde bei Raumtemperatur weitergerührt, wobei das Polyvinylacetal allmählich ausfiel. Nach 4 Stunden wurden nochmals 20 g konz. Salzsäure zugetropft und weitere 2 Stunden bei 35° C gerührt. Das Produkt wurde von der wäßrigen Lösung abgetrennt, in 2-Methoxy-ethanol gelöst und aus Wasser umgefällt. Man erhielt 80 g eines weißen, faserigen Materials, welches einen Acetalisierungsgrad von 52 % aufwies.

20 g des so erhaltenen, getrockneten Benzaldehydacetals wurden in 500 ml Tetrahydrofuran gelöst. Zur klaren Lösung wurden bei Raumtemperatur unter Rühren 22 g Ethylmethylphosphinsäureisocyanat zugetropft. Nach 5 Stunden wurde diese Mischung in 5000 g Wasser eingetropft. Das ausgefallene Produkt wurde im Vakuum getrocknet und wies eine Säurezahl von 109 auf.

Eine Beschichtungslösung aus

86,5 Gt des oben beschriebenen Bindemittels,
29 Gt des in Beispiel 1 beschriebenen Diazoniumsalzpolykondensats,
3,5 Gt Phosphorsäure (85 %ig),
4,3 Gt Viktoriareinblau FGA (C.I. Basic Blue 81)
und 1 Gt Phenylazodiphenylamin in
4200 Gt Ethylenglykolmonomethylether

wurde auf eine in Salpetersäure elektrochemisch aufgerauhte und anschließend anodisierte Aluminiumfolie, die mit Polyvinylphosphonsäure nachbehandelt worden war, aufgebracht. Das Trockenschichtgewicht betrug 1,03 g/m².

Die weitere Verarbeitung erfolgte entsprechend Beispiel 1. Man erhielt eine Druckform, die an den Bildstellen sehr gut farbannehmend, an den Nichtbildstellen aber tonfrei war. Mit der in einer Bogenoffsetmaschine eingespannten Druckform wurden mehr als 140.000 qualitativ einwandfreier Drucke erhalten.

Anwendungsbeispiel 3

Eine Beschichtungslösung wurde hergestellt aus

26,8 Gt einer 8 %igen Lösung des im Herstellungsbeispiel 5 beschriebenen Umsetzungsprodukts in Tetrahydrofuran,
2,2 Gt 2,6-Bis(4-azidobenzal)-4-methylcyclohexanon und
0,3 Gt Rhodamin 6 GDN extra (C.I. 45 160) in
120 Gt Ethylenglykolmonomethylether und
30 Gt Butylacetat.

Die Lösung wurde auf den in Beispiel 2 beschriebenen Schichtträger aufgebracht, wobei ein Trockenschichtgewicht von 0,8 g/m$^2$ erhalten wurde. Die Verarbeitung erfolgte wie in Beispiel 1 beschrieben. Mit der so erhaltenen Druckform wurden an einer Bogenoffsetmaschine mehrere Zehntausend guter Drucke erzielt.

Anwendungsbeispiel 4

Analog zum Herstellungsbeispiel 4 wurde ein Umsetzungsprodukt aus 20 g eines Polyvinylbutyrals, welches 71 Gew.-% Vinylbutyral-, 2 Gew.-% Vinylacetat und 27 Gew.-% Vinylalkoholeinheiten enthielt, und 12,8 g Chlormethylmethylphosphinsäureisocyanat in 400 g Tetrahydrofuran synthetisiert. Das Produkt hatte nach Trocknen eine Zusammensetzung von C: 53,2 %, H: 8,3 %, N: 2,4 %, P: 5,8 % und Cl: 6,5 % und die Säurezahl 61.
Eine Beschichtungslösung wurde aus

26,7 Gt einer 8 %igen Lösung des oben beschriebenen Umsetzungsprodukts in Tetrahydrofuran,
2,2 Gt der im Anwendungsbeispiel 3 beschriebenen Bisazidoverbindung,
0,3 Gt Rhodamin 6 GDN extra (C.I. 45160) und
0,2 Gt 2-Benzoylmethylen-1-methyl-ß-naphthothiazolin in
100 Gt Ethylenglykolmonomethylether und
50 Gt Tetrahydrofuran

hergestellt.
Die Lösung wurde auf den im Anwendungsbeispiel 2 beschriebenen Träger zu einem Trockenschichtgewicht von0,72 g/m$^2$ aufgetragen. Die Kopierschicht wurde anschließend unter einer Negativvorlage 35 Sekunden lang mit einer Metallhalogenid-Lampe von 5 kW Leistung belichtet; dabei entstand ein gut sichtbares dunkelrotes Bild. Die Schicht wurde mittels eines Plüschtampons mit einer Entwicklerlösung aus

5 Gt Natriumlaurylsulfat und
1 Gt Natriummetasilikat × 5 $H_2O$ in
94 Gt Wasser

behandelt, wobei Nichtbildstellen entfernt wurden. Nach Spülung mit Wasser war beim Einfärben die Stufe 5 des im Anwendungsbeispiel 1 beschriebenen Silberfilm- Halbtonstufenkeils geschwärzt. Die erhaltene Druckplatte lieferte an einer Bogenoffsetmaschine eine Auflage von mehr als 160.000 Bogen.

Anwendungsbeispiel 5

Eine Beschichtungslösung wurde hergestellt aus

2 Gt des im Herstellungsbeispiel 4 beschriebenen Bindemittels,
2 Gt Trimethylolpropantrimethacrylat,
0,1 Gt Kristallviolett (C.I. 42 555)
0,08 Gt 2-Ethylanthrachinon und
0,01 Gt 4-Methoxyphenol in
40 Gt Ethylenglykolmonomethylether.

Nach der Filtration wurde die Lösung auf eine Aluminiumfolie, welche analog zum Anwendungsbeispiel 2 vorbehandelt worden war, aufgetragen und 2 Stunden bei 100° C zu einem Trockenschichtgewicht von 4 g/m$^2$ getrocknet. Nach dem Trocknen wurde die Schicht mit einer 3 %igen Polyvinylalkohol-Lösung überzogen, die zu einem Gewicht von etwa 1 g/m$^2$ trocknete. Nach der Belichtung unter einem Negativ wurde mit einer 2 %igen Trinatriumphosphatlösung entwickelt. Man erhielt innerhalb von 30 Sekunden ein klares Bild, welches vor dem Einfärben mit Schutzfarbe mit einer 1 %igen wäßrigen Phosphorsäurelösung überwischt wurde. Die Druckform nahm die Schutzfarbe sehr gut an und leistete auf den üblichen Offsetpressen hohe Auflagen.

Anwendungsbeispiel 6

Eine Beschichtungslösung wurde bereitet aus

2 Gt eines Polymeren, das erhalten wurde durch Umsetzung des im Anwendungsbeispiel 1 eingesetzten Polyvinylbutyrals mit Diphenylphosphinsäureisocyanat und die Säurezahl 94 aufwies (C: 61,7 %, H: 8,5 %, N: 2,8 %, P: 5,8 %),
2,2 Gt des Umsetzungsprodukts aus 1 mol 2,2,4-Trimethyl-hexamethylendiisocyanat und 2 mol Hydroxyethylmethacrylat,
0,2 Gt 2-(4'-Methoxystyryl)-4,6-bis-trichlormethyl-s-triazin und
0,06 Gt eines Azofarbstoffs aus 2,4-Dinitro-6-chlorbenzoldiazoniumsalz und 2-Methoxy-5-acetylamino-N-cyanoethyl-N-hydroxyethyl-anilin in
26 Gt Butanon und
14 Gt Butylacetat.

Die Lösung wurde auf einen wie im Anwendungsbeispiel 2 vorbehandelten Aluminiumträger derart aufgeschleudert, daß ein Trockenschichtgewicht von etwa 4,3 g/m² erhalten wurde.
Die getrocknete Platte wurde mit einer 5 kW Metallhalogenidlampe unter einem Halbtonstufenkeil im Abstand von 110 cm zwichen Lampe und Vakuumkopierrahmen 40 Sekunden belichtet. Anschließend wurde die Platte manuell mit einem Entwickler folgender Zusammensetzung entwickelt:

3,0 Gt Natriummetasilikat × 9 $H_2O$ und
0,04 Gt nichtionogenes Netzmittel (Kokosfettalkoholpolyoxyethylenether mit ca. 8 Oxyethyleneinheiten) in
96,96 Gt Wasser.

Man erhielt eine Druckform mit 5 vollvernetzten Keilstufen, die beim Einspannen in eine Bogenoffsetmaschine 180.000 hochaufgelöster Drucke lieferte.

Anwendungsbeispiel 7

Ein Terpolymerisat aus 50 Gew.-% Hydroxyethylmethacrylat, 20 Gew.-% Methylmethacrylat und 30 Gew.-% Hexylmethacrylat wurde mit einem Überschuß von Ethylmethylphosphinsäureisocyanat derart versetzt, daß alle Hydroxylgruppen in Phosphinylurethangruppierungen übergeführt wurden. Das erhaltene Polymere hatte ein mittleres Molekulargewicht von ca. 32.000.
Aus 6,5 Gt des oben beschriebenen Umsetzungsprodukts,
5,6 Gt eines technischen Gemischs aus Pentaerythrittri- und -tetramethacrylat,
0,2 Gt 2-(4'-Methoxystyryl)-4,6-bis-trichlormethyl-s-triazin und
0,03 Gt des im Anwendungsbeispiel 6 angegebenen Azofarbstoffs in
25 Gt Butanon,
2 Gt Ethanol und
1 Gt Butylacetat

wurde eine Lösung bereitet, die auf eine biaxial verstreckte und thermofixierte Polyethylenterephthalatfolie der Stärke 25 µm so aufgeschleudert wurde, daß nach dem Trocknen bei 100° C ein Trockenschichtgewicht von 35 g/m² erhalten wurde.
Die derart hergestellte Trockenresistfolie wurde mit einer Laminiervorrichtung bei 120° C auf eine mit 35 µm starker Kupferfolie kaschierte Phenoplast-Schichtstoffplatte laminiert und 25 Sekunden unter einem handelsüblichen Belichtungsgerät belichtet. Als Vorlage diente eine Strichvorlage mit Linienbreiten und Abständen bis herab zu 80 µm.
Nach der Belichtung wurde die Polyesterfolie abgezogen und die erhaltene Schicht mit einer Entwicklerlösung der im Anwendungsbeispiel 6 angegebenen Zusammensetzung in einem Sprühentwicklungsgerät 90 Sekunden entwickelt. Anschließend wurde 30 Sekunden mit Leitungswasser gespült, 30 sekunden in einer 15 %igen Ammoniumperoxydisulfat-Lösung angeätzt und anschließend in folgenden Elektrolytbädern galvanisiert:

1) 30 Minuten in einem Kupferelektrolyten der Fa. Schlötter, Geislingen/Steige, Typ "Glanzkupfer-Bad".
Stromdichte: 2,5 A/dm².
Metallaufbau: ca. 14 µm.
2) 10 Minuten in einem Nickelbad des gleichen Herstellers, Typ "Norma".
Stromdichte: 4 A/dm²

Metallaufbau: 9 µm.

Die Platte zeigte keinerlei Beschädigungen oder Unterwanderungen. Die Entschichtung erfolgte in 5 %iger KOH-Lösung bei 50° C. Das freigelegte Kupfer wurde mit den üblichen Ätzmedien weggeätzt.

Anwendungsbeispiel 8

Es wurde eine Beschichtungslösung aus

16,0 Gt einer 8,0 %igen Lösung des im Herstellungsbeispiel 6 beschriebenen Umsetzungsprodukts in Butanon,
0,725 Gt des im Anwendungsbeispiel 1 beschriebenen Diazoniumsalz-Polykondensationsprodukts,
0,072 Gt Phosphorsäure (85 %),
0,01 Gt Phenylazodiphenylamin und
0,07 Gt Kristallviolett (C.I. 42 555) in
140 Gt Ethylenglykolmonomethylether

bereitet und auf einen wie in Anwendungsbeispiel 2 vorbehandelten Aluminiumträger aufgeschleudert, so daß ein Trockenschichtgewicht von 0,8 g/m² erhalten wurde.

Die belichtete Schicht wurde 15 Sekunden in eine Küvette getaucht, die die im Anwendungsbeispiel 4 beschriebene Entwicklerlösung enthielt. Nach Abbrausen mit Leitungswasser wurde ein randscharfes Abbild der Vorlage erhalten, welches mehrere Tausend guter Drucke erzeugte.

Anwendungsbeispiel 9

20 Gt des im Herstellungsbeispiel 4 angegebenen Polyvinylbutyrals wurden mit 19,4 Gt Ethylmethylphosphinsäureisocyanat in 300 Gt Tetrahydrofuran, wie dort beschrieben, zu einem Produkt mit einer Säurezahl von 148 umgesetzt.

Eine Beschichtungslösung wurde hergestellt aus

30,3 Gt des oben beschriebenen Umsetzungsprodukts,
15,1 Gt des im Anwendungsbeispiel 1 angegebenen Diazoniumsalz-Polykondensats,
1,2 Gt Phosphorsäure (85 %),
1,1 Gt Phenylazodiphenylamin und
1,5 Gt Viktoriareinblau FGA (C.I. Basic Blue 81) in
1600 Gt Ethylenglykolmonomethylether.

Die Lösung wurde auf einen elektrolytisch in Salzsäure aufgerauhten, anodisierten und mit Polyvinylphosphonsäure nachbehandelten Träger aus Aluminium aufgebracht und zu einem Schichtgewicht von 1,2 g/m² getrocknet. Die vorsensibilisierte Druckform wurde entsprechend Anwendungsbeispiel 1 belichtet, entwickelt und in einer Bogenoffsetmaschine eingesetzt. Man erhielt eine Druckauflage von etwa 200.000 sehr guter Drucke.

Anwendungsbeispiel 10

Die im Anwendungsbeispiel 4 erhaltene Druckform wurde nach Belichtung und Entwicklung einer Einbrennbehandlung unterzogen. Dabei wurde das Material gummiert und dann 5 Minuten auf 220° C erhitzt. Die abgekühlte Druckform wurde in einer Bogenoffsetmaschine eingesetzt. Mit ihr wurden mehr als 250.000 sehr gut aufgelöster Drucke erhalten.

Anwendungsbeispiel 11

Analog zum Herstellungsbeispiel 4 wurden 15 Gt eines Terpolymerisats aus 91 % Vinylchlorid, 3 % Vinylacetat und 6 % Vinylalkohol, mit einem mittleren Molekulargewicht von 15.000 und einem Erweichungspunkt von ca. 75° C mit 8 Gt Diphenylphosphinsäureisocyanat umgesetzt. Das erhaltene Produkt hatte die Säurezahl 47.

Eine Beschichtungslösung wurde hergestellt aus

44,9 Gt einer 8,03 %igen Lösung des oben beschriebenen Umsetzungsprodukts in Tetrahydrofuran,
1,8 Gt des im Anwendungsbeispiel 1 angegebenen Diazoniumsalz-Polykondensats,
0,2 Gt Phosphorsäure (85 %),
0,1 Gt Viktoriareinblau FGA (C.I. Basic Blue 81) und
0,06 Gt Phenylazodiphenylamin in
150,0 Gt Ethylenglykolmonomethylether.

Die Lösung wurde auf eine elektrochemisch aufgerauhte und anodisierte Aluminiumfolie, die mit Polyvinylphosphonsäure nachbehandelt worden war, aufgebracht. Das Schichtgewicht der lichtempfindlichen Schicht betrug nach dem Trocknen 0,96 g/m². Die Verarbeitung wurde analog zum Anwendungsbeispiel 4 durchgeführt. An einer Bogenoffsetmaschine wurden mit dieser Druckform hohe Auflagenleistungen erzielt.

Anwendungsbeispiel 12

Eine Beschichtungslösung wurde hergestellt aus

1,5 Gt des im Herstellungsbeispiel 4 beschriebenen Umsetzungsprodukts, allerdings mit einer Säurezahl von 80,
0,5 Gt eines Diazoniumsalz-Polykondensationsprodukts aus 1 mol 3-Methoxy-diphenylamin-4-diazoniumsulfat und je 1 mol 4-Methoxymethyl-4'-methyl-diphenylether und 1,4-Bis-methoxymethyl-benzol, ausgefällt als 2-Hydroxy-4-methoxy-benzophenon-5-sulfonat,
0,1 Gt Viktoriareinblau FGA (C.I. Basic Blue 81),
1,5 Gt Pentaerythrittri- und -tetraacrylat (technisches Gemisch),
0,1 Gt 2-(4'-Styrylphenyl)-4,6-bis-trichlormethyl-s-triazin und
0,05 Gt Phosphorsäure (85 %) in
48,0 Gt Ethylenglykolmonomethylether und
42,0 Gt Tetrahydrofuran

und auf eine elektrochemisch aufgerauhte, anodisierte und mit Polyvinylphosphonsäure nachbehandelte Aluminiumplatte aufgetragen. Es wurde zu einem Trockenschichtgewicht von 1,8 g/m² getrocknet. Die erhaltene Druckplatte wurde unter einer geeigneten Testvorlage belichtet und mit einem Entwickler folgender Zusammensetzung entwickelt:

0,2 Gt Natriummetasilikat × 9 $H_2O$,
3,9 Gt Dinatriumhydrogenphosphat × 12 $H_2O$,
3,5 Gt Trinatriumphosphat × 12 $H_2O$,
1,5 Gt Kaliumtetraborat × 4 $H_2O$ und
2,9 Gt Natriumoctylsulfat in
88,0 Gt entsalztem Wasser.

Mit der entwickelten Druckform wurden in einer Offset-Bogenpresse mehr als 200.000 Drucke erhalten.

Anwendungsbeispiel 13

Das im Anwendungsbeispiel 7 beschriebene Terpolymerisat wurde mit einem Überschuß von Dimethylthiophosphinsäureisocyanat so umgesetzt, daß alle Hydroxylgruppen in Thiophosphinylurethangruppierungen übergeführt wurden.
Es wurde eine Beschichtungslösung aus

6,5 Gt des oben beschriebenen Umsetzungsprodukts,
5,6 Gt 4,4'-Bis-(ß-acryloyloxyethoxy)diphenylether,
0,2 Gt 2-(4'-Methoxystyryl)-4,6-bis-trichlormethyl-s-triazin und
0,03 Gt des im Anwendungsbeispiel 6 beschriebenen Azofarbstoffs in
25,0 Gt Butanon,
2,0 Gt Ethanol und
1,0 Gt Butylacetat

bereitet und analog zum Anwendungsbeispiel 7 weiterverarbeitet, wobei die Lösung auf eine mit 35 µm starker Kupferfolie kaschierte Phenoplast-Schichtstoffplatte aufgeschleudert und ein Trockenschichtgewicht von 30 g/m² erhalten wurde. Anschließend wurde die Platte belichtet, entwickelt und galvanisiert, wobei sie anstelle der Vernickelung 15 Minuten in einem Bleizinnbad LA der Firma Schlötter, Geislingen/Steige bei einer Stromdichte von 1 A/dm² (Metallaufbau: 15 µm) behandelt wurde. Auch diese Platte zeigte keinerlei Beschädigungen oder Unterwanderungen. Die Entschichtung erfolgte, wie im Anwendungsbeispiel 7 beschrieben, in einer 5 %igen KOH-Lösung bei 50° C. Das freigelegte Kupfer konnte mit dem üblichen Ätzmedium weggeätzt werden.

Anwendungsbeispiele 14 - 16

Analog zum Herstellungsbeispiel 4 wurden Umsetzungsprodukte des dort beschriebenen Polyvinylbutyrals mit jeweils gleichen molaren Mengen

Anwendungsbeispiel 14: Chlormethylmethylphosphinsäureisocyanat
Anwendungsbeispiel 15: Methylphenylphosphinsäureisocyanat
Anwendungsbeispiel 16: Diphenylphosphinsäureisocyanat
umgesetzt.

Die erhaltenen Bindemittel mit Säurezahlen zwischen 60 und 80 wurden wie im Anwendungsbeispiel 1 zu Lösungen verarbeitet. Diese wurden auf eine in Salpetersäure elektrochemisch aufgerauhte, anodisierte und mit Polyvinylphosphonsäure nachbehandelte Aluminiumfolie aufgetragen. Man erhielt lichtempfindliche Schichten mit einem Trockenschichtgewicht von etwa 1 g/m$^2$. Nach bildmäßiger Belichtung wurde mit einem Entwickler der Zusammensetzung des Anwendungsbeispiels 12 entwickelt. Dabei beobachtete man eine Abnahme der Entwicklungsgeschwindigkeit mit zunehmender aromatischer Substitution des Phosphinsäureisocyanats. Die entwickelten Druckformen wurden in einer Bogenoffsetmaschine angedruckt. In allen drei Fällen wurde die Farbe nach den ersten 5 bis 6 Bogen von den druckenden Schichtbereichen der Druckform angenommen.

Anwendungsbeispiele 17 - 19

In diesen Beispielen wurden verschiedene hydroxylgruppenhaltige Polymere verwendet, die mit einer konstanten Menge Ethylmethylphosphinsäureisocyanat umgesetzt wurden. Die Polymeren wurden, wie im Herstellungsbeispiel 4 beschrieben, in Beschichtungslösungen eingesetzt, die in ihrer Zusammensetzung der im Anwendungsbeispiel 1 beschriebenen entsprachen. Die Verarbeitung erfolgte analog zu Anwendungsbeispiel 1. In allen Fällen wurden Kopien hoher Qualität erhalten, in welchen die feinsten Strichelemente der Vorlage klar wiedergegeben wurden. In der Druckmaschine erwiesen sie sich als chemisch und mechanisch außerordentlich resistent und lieferten hohe Auflagen.

Anwendungsbeispiel 17

20 Gt des im Herstellungsbeispiel 4 beschriebenen Polyvinylbutyrals wurden mit 14 Gt Ethylmethylphosphinsäureisocyanat in 350 Gt Tetrahydrofuran umgesetzt und wie dort beschrieben aufgearbeitet. Das Polymere hatte eine Säurezahl von 102 und eine Zusammensetzung von C: 52,3 %, H: 8,6 %, N: 3,6 % und P: 7,9.

Anwendungsbeispiel 18

20 Gt eines Polyvinylbutyrals mit einem Molekulargewicht von etwa 80.000, das 79 Gew.-% Vinylbutyral-, 2 Gew.-Vinylacetat- und 21 Gew.-% Vinylalkoholeinheiten enthielt, wurden mit 14 Gt Ethylmethylphosphinsäureisocyanat in 350 Gt Tetrahydrofuran umgesetzt. Das Polymer wies eine Zusammensetzung von C: 53,9 %, H: 9,3 %, N: 3,4 % und P: 7,4 auf und hatte eine Säurezahl von 92.

Anwendungsbeispiel 19

20 Gt eines Polyvinylbutyrals mit einem Molekulargewicht von etwa 80.000, das 86 Gew.-% Vinylbutyral-, 2 Gew.-% Vinylacetat- und 12 Gew.-% Vinylalkohleinheiten enthielt, wurden mit 14 Gt. Ethylmethylphosphinsäureisocyanat in 350 Gt Tetrahydrofuran umgesetzt. Das Polymer wies eine Zusammensetzung von C: 55,1 %, H: 9,3 %, N: 3,0 % und P: 6,5 % auf und hatte eine Säurezahl von 77.

Anwendungsbeispiel 20

Eine Kopierschicht analog zu Anwendungsbeispiel 2 wurde auf fünf wie dort behandelte Aluminiumfolien aufgetragen. Die fünf erhaltenen Flachdruckplatten wurden in einem auf 100° C vorgeheizten Trockenschrank eine bis fünf Stunden gelagert.
Die abgekühlten Kopierschichten wurden 25 Sekunden unter einer Negativvorlage belichtet und dann mit einem Entwickler der folgenden Zusammensetzung

3,9 Gt $Na_2HPO_4 \times 12\ H_2O$,
1,9 Gt Kaliumoxalat $\times\ H_2O$,
1,5 Gt Kaliumtetraborat $\times 4\ H_2O$,
3,4 Gt $Na_3PO_4 \times 12\ H_2O$,
2 Gt Phenoxyethanol,
2,5 Gt Natriumbenzoat und
84,8 Gt Wasser

entwickelt.
Während die eine bis zwei Stunden im Heizschrank gelagerten Platten gegenüber einer normal verarbeiteten Kopie keine nennenswerte Verlängerung des Stufenkeils oder eine Verzögerung der Entwicklungsgeschwindigkeit zeigten, wurde bei der drei Stunden gelagerten Platte eine merkliche Verzögerung der Entwicklung und eine verlängerte Wiedergabe des Keils um 1 bis zwei Stufen beobachtet. Die vier Stunden gelagerte Platte zeigte auch an den Nichtbildbereichen eine Neigung zur Farbannahme, während die fünf Stunden gelagerte Platte fast nicht mehr entwickelbar war. Die entwickelten Schichtbereiche neigten zur Fladenbildung, und die Nichtbildstellen nahmen deutlich Farbe an.

Diese Ergebnisse zeigten, daß die Kopierschicht gegenüber Hitze relativ unempfindlich war.

Anwendungsbeispiel 21

Die im Anwendungsbeispiel 1 beschriebene Schicht wurde auf den im Anwendungsbeispiel 2 angegebenen Schichtträger aufgeschleudert. Das Schichtgewicht betrug etwa 1 $g/m^2$. Vier Platten dieses Typs wurden in einem Tropenschrank gelagert, der auf 40° C erwärmt war und eine relative Feuchtigkeit von 60 % aufwies. Jeweils eine Platte wurde nach 3, 6, 9 und 12 Monaten herausgenommen, bildmäßig belichtet und mit dem Entwickler des Anwendungsbeispiels 20 entwickelt. Zum Vergleich wurde eine nicht unter diesen Bedingungen gelagerte Platte herangezogen, die bei einer Belichtung von 25 Sekunden eine gedeckte Stufe 4 eines Silberfilm-Halbtonstufenkeils mit einem Dichteumfang von 0,15 bis 1,50 bei Dichteinkrementen von 0,15 zeigte. Die nach drei, sechs und neun Monaten belichteten Platten zeigten keine Verlängerung des Stufenkeils. Ihre Entwicklung ging ebenso rasch vonstatten, wie die der Originalplatte. Die ein Jahr im Tropenschrank gelagerte Platte zeigte eine Verlängerung des Stufenkeils um eine bis zwei Stufen, aber auch ihre Entwicklung verlief zügig. Alle Platten wurden in einer Druckmaschine angedruckt und zeigten keine Probleme bezüglich Farbannahme oder Tonneigung.

Anwendungsbeispiel 22

20 Gt eines Polyamids (Ultramid 1C(R), BASF) wurden ca. 12 Stunden in 200 Gt Phosphorsäure-tris-dimethylamid angequollen und anschließend unter heftigem Rühren innerhalb von etwa 4 Stunden bei 50° C gelöst. Zu der klaren Lösung wurde bei etwa 40° C ein Gemisch aus 50 Gt des gleichen Lösungsmittels und 15 Gt 1-Isocyanato-1-oxo-2,3-dihydrophosphol zugetropft, und es wurde etwa 8 Stunden nachgerührt, wobei man die Mischung auf Raumtemperatur abkühlen ließ. Das Gemisch wurde durch Eintropfen in eine stark gerührte Mischung aus 10 % Ethanol und 90 % destilliertem Wasser ausgefällt, filtriert, nachgewaschen und bei Raumtemperatur getrocknet. Das Produkt war in 1 n Natronlauge löslich.

Das Bindemittel wurde in einer dem Anwendungsbeispiel 1 entsprechenden Rezeptur verarbeitet und auf eine elektrochemisch aufgerauhte, anodisierte und nachbehandelte Aluminiumfolie aufgetragen. Das Schichtgewicht betrug 1,4 $g/m^2$.

Nach bildmäßiger Belichtung und Entwicklung mit einem Entwicklergemisch, das

5 Gt Benzylalkohol,
2 Gt Natriumhydroxid und
2 Gt Natriumdecylsulfat in
91 Gt Wasser

enthielt, wurde die Druckform in eine Bogenoffsetmaschine eingespannt. Man erhielt mehrere 10.000 qualitativ einwandfreier Drucke.

## Patentansprüche

1. Lichtempfindliches Gemisch, das als wesentliche Bestandteile eine lichtempfindliche Verbindung und ein polymeres wasserunlösliches, in wäßrig-alkalischen Lösungen lösliches oder quellbares Bindemittel enthält, dadurch gekennzeichnet, daß das polymere Bindemittel ein Umsetzungsprodukt einer Verbindung der allgemeinen Formel I

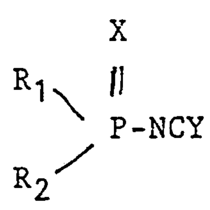 (I) ,

worin

X und Y gleich oder verschieden sind und Sauerstoff oder Schwefel bedeuten,
$R_1$ und $R_2$ gleich oder verschieden sind und ggf. substituierte Alkyl-, Cycloalkyl- oder Alkoxyreste mit 1

bis 6 C-Atomen, ggf. substituierte Aryl- oder Aryloxyreste mit 6 bis 10 C-Atomen oder gemeinsam mit dem Phosphoratom einen 5- oder 6-gliedrigen heterocyclischen Ring bedeuten, der ggf. substituiert ist oder einen ankondensierten Benzolring trägt,

mit einem aktiven Wasserstoff enthaltenden Polymeren ist.

2. Lichtempfindliches Gemisch nach Anspruch 1, dadurch gekennzeichnet, daß $R_1$ und $R_2$ Alkyl- oder Alkoxyreste mit 1 bis 4 C-Atomen sind.

3. Lichtempfindliches Gemisch nach Anspruch 1 oder 2, dadurch gekennzeichnet, daß $R_1$ und $R_2$ gegebenenfalls substituierte Phenyl- oder Phenoxyreste sind.

4. Lichtempfindliches Gemisch nach einem der Ansprüche 1 bis 3, dadurch gekennzeichnet, daß X und Y Sauerstoffatome sind.

5. Lichtempfindliches Gemisch nach Anspruch 1, dadurch gekennzeichnet, daß das aktiven Wasserstoff enthaltende Polymere ein Hydroxyl- oder Aminogruppen enthaltendes Polymeres ist.

6. Lichtempfindliches Gemisch nach Anspruch 5, dadurch gekennzeichnet, daß das Hydroxyl- oder Aminogruppen enthaltende Polymere ein Vinylalkohol-, Allylalkohol-, Hydroxyalkylacrylat- oder Hydroxyalkylmethacrylateinheiten enthaltendes Polymerisat, ein Epoxyharz, Celluloseether, Celluloseester oder Polyester mit freien Hydroxylgruppen oder ein Polyamin, Polyamid oder Polyurethan ist.

7. Lichtempfindliches Gemisch nach Anspruch 1, dadurch gekennzeichnet, daß die lichtempfindliche Verbindung ein Photoinitiator für die radikalische Polymerisation ist und daß das Gemisch ferner eine polymerisierbare Verbindung mit mindestens einer ethylenischen Doppelbindung enthält.

8. Lichtempfindliches Gemisch nach Anspruch 7, dadurch gekennzeichnet, daß der Photoinitiator mindestens eine durch Belichtung spaltbare Trihalogenmethylgruppe enthält.

9. Lichtempfindliches Gemisch nach Anspruch 1, dadurch gekennzeichnet, daß die lichtempfindliche Verbindung eine bei Belichtung vernetzende Verbindung ist.

10. Lichtempfindliches Gemisch nach Anspruch 8, dadurch gekennzeichnet, daß die bei Belichtung vernetzende Verbindung ein Diazoniumsalz, ein p-Chinondiazid oder eine organische Azidoverbindung ist.

11. Lichtempfindliches Aufzeichnungsmaterial mit einem Schichtträger und einer lichtempfindlichen Schicht, dadurch gekennzeichnet, daß die lichtempfindliche Schicht aus dem lichtempfindlichen Gemisch gemäß einem der Ansprüche 1 bis 10 besteht.

**Claims**

1. Photosensitive mixture which contains as the essential constituents a photosensitive compound and a polymeric binder which is insoluble in water and soluble or swellable in aqueous-alkaline solutions, wherein the polymeric binder is a reaction product of a compound of the general formula I

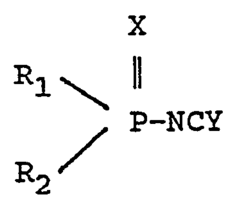

(I)

wherein

X and Y are the same or different and denote oxygen or sulfur,

$R_1$ and $R_2$ are the same or different and denote unsubstituted or substituted alkyl, cycloalkyl or alkoxy radicals containing from 1 to 6 carbon atoms, unsubstituted or substituted aryl or aryloxy radicals containing from 6 to 10 carbon atoms or, together with the phosphorus atom, a 5- or 6-membered heterocyclic ring which is unsubstituted or substituted or carries a fused benzene ring, with a polymer containing active hydrogen.

2. A photosensitive mixture as claimed in claim 1, wherein $R_1$ and $R_2$ are alkyl or alkoxy radicals containing from 1 to 4 carbon atoms.

3. A photosensitive mixture as claimed in claim 1 or claim 2, wherein $R_1$ and $R_2$ are unsubstituted or substituted phenyl or phenoxy radicals.

4. A photosensitive mixture as claimed in any of claims 1 to 3, wherein X and Y are oxygen atoms.

5. A photosensitive mixture as claimed in claim 1 wherein the polymer containing active hydrogen is a polymer containing hydroxyl or amino groups.

6. A photosensitive mixture as claimed in claim 5 wherein the polymer containing hydroxyl or amino groups is a polymer containing vinyl-alcohol, allyl-alcohol, hydroxyalkyl-acrylate or hydroxyalkyl-methacrylate units, an epoxy resin, a cellulose ether, a cellulose ester or a polyester containing free hydroxyl groups or a polyamine, a polyamide or a polyurethane.

7. A photosensitive mixture as claimed in claim 1, wherein the photosensitive compound is a photoinitiator for the polymerization by free radicals and wherein the mixture additionally contains a polymerizable compound having at least one ethylenic double bond.

8. A photosensitive mixture as claimed in claim 7, wherein the photoinitiator contains at least one trihalomethyl group which is cleavable by exposure to light.

9. A photosensitive mixture as claimed in claim 1, wherein the photosensitive compound is a compound which crosslinks on exposure.

10. A photosensitive mixture as claimed in claim 8, wherein the compound which crosslinks on exposure is a diazonium salt, a p-quinone diazide or an organic azido compound.

11. Photosensitive recording material comprising a support and a photosensitive layer, wherein the photosensitive layer is formed of the photosensitive mixture as claimed in any of claims 1 to 10.

**Revendications**

1. Composition photosensible contenant en tant que composants essentiels un composé photosensible et un liant polymère insoluble dans l'eau, soluble ou susceptible de gonfler dans des solutions aqueuses alcalines, caractérisée en ce que le liant polymère est un produit de réaction d'un composé de formule générale I

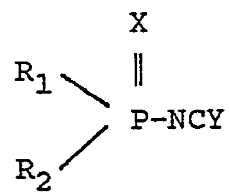 (I)

dans laquelle

X et Y sont identiques ou différents, et représentent un atome d'oxygène ou de soufre,

$R_1$ et $R_2$ sont identiques ou différents, et représentent des radicaux alkyle, cycloalkyle ou alcoxy éventuellement substitués, ayant de 1 à 6 atomes de carbone, des radicaux aryle ou aryloxy éventuellement substitués ayant de 6 à 10 atomes de carbone, ou, conjointement avec l'atome de phosphore, forment un cycle hétérocyclique à 5 ou 6 chaînons, qui est éventuellement substitué ou porte un noyau benzénique fusionné,

avec un polymère contenant un hydrogène actif.

2. Composition photosensible selon la revendication 1, caractérisée en ce que $R_1$ et $R_2$ sont des radicaux alkyle ou alcoxy ayant de 1 à 4 atomes de carbone.

3. Composition photosensible selon la revendication 1 ou 2, caractérisée en ce que $R_1$ et $R_2$ sont des radicaux phényle ou phénoxy éventuellement substitués.

4. Composition photosensible selon l'une des revendications 1 à 3, caractérisée en ce que X et Y sont des atomes d'oxygène.

5. Composition photosensible selon la revendication 1, caractérisée en ce que le polymère contenant de l'hydrogène actif est un polymère contenant des groupes hydroxy ou amino.

6. Composition photosensible selon la revendication 5, caractérisée en ce que le polymère contenant des groupes hydroxy ou amino est un polymère contenant des motifs alcool vinylique, alcool allylique, acrylate d'hydroxyalkyle ou méthacrylate d'hydroxyalkyle, une résine époxy, un éther de cellulose, un ester de cellulose ou un polyester à groupes hydroxy libres ou une polyamine, un polyamide ou un polyuréthanne.

7. Composition photosensible selon la revendication 1, caractérisée en ce que le composé photosensible est un photoinitiateur de la polymérisation radicalaire, et en ce que la composition contient en outre un composé polymérisable comportant au moins une double liaison éthylénique.

8. Composition photosensible selon la revendication 7, caractérisée en ce que le photoinitiateur contient au moins un groupe trihalogénométhyle séparable par insolation.

9. Composition photosensible selon la revendication 1, caractérisée en ce que le composé photosensible est un composé se réticulant lors d'insolation.

10. Composition photosensible selon la revendicaton 8, caractérisée en ce que le composé se réticulant lors d'insolation est un sel de diazonium, un p-quinonediazide ou un composé azido organique.

11. Matériau photosensible de reprographie comprenant un support de couche et une couche photosensible, caractérisé en ce que la couche photosensible est constituée de la composition photosensible selon l'une des revendications 1 à 10.